# DEMANDE DE BREVET EUROPEEN

(11) **EP 2 463 909 A2**
(43) Date de publication de la demande: **13.06.2012**
(21) Numéro de dépôt: 11192183.9
(22) Date de dépôt: 06.12.2011
(51) Int. Cl.: H01L 27/146

(54) **Procédé de fabrication de dispositifs semi-conducteurs et dispositifs semi-conducteurs**

(30) Priorité: 08.12.2010 FR 1060248
(71) Demandeur: STMicroelectronics (Grenoble 2) SAS, 38000 Grenoble (FR)
(72) Inventeur: Vigier-Blanc, Emmanuelle, 38700 Le Sappey en Chartreuse (FR)
(74) Mandataire: Zapalowicz, Francis

(57) **Abrégé**

Procédé de fabrication de dispositifs semi-conducteurs et dispositifs semi-conducteurs, dans lesquels une plaquette de circuits intégrés (20b) est munie d'une plaquette optique (15) et est équipée d'une seconde plaquette démontable (16) au-dessus de la première plaquette (15) lors de la fabrication de puces de circuits intégrés (2) incluses dans ladite plaquette de circuits intégrés (20b).

## Description

La présente invention concerne le domaine des dispositifs semi-conducteurs, et plus particulièrement des dispositifs semi-conducteurs optiques.

La fabrication de puces de circuits intégrés comprenant des vias de connexion électrique traversant le substrat (souvent dénommés TSV) et des moyens arrière de connexion électrique extérieure nécessite le montage des plaquettes de fabrication collective des puces sur des plaquettes épaisses, ces plaquettes étant du côté des circuits intégrés.

Dans le cas particulier où les puces comprennent des éléments optiques tels que des capteurs ou des émetteurs de rayonnement lumineux, les plaquettes, qui sont choisies de façon à être traversées par un rayonnement lumineux, restent fixées sur les plaquettes-substrats de fabrication collective des puces, si bien que les dispositifs semi-conducteurs optiques obtenus après singularisation comprennent des plaques optiques épaisses devant leurs éléments optiques, ce qui a tendance à perturber le chemin du rayonnement lumineux qui les traversent.

De tels dispositifs semi-conducteurs optiques sont utilisés dans les appareillages d'imagerie, notamment dans les appareillages d'imagerie médicale, ainsi qu'en géophysique et en astrophysique.

Il est proposé un procédé de fabrication de dispositifs semi-conducteurs.

Ce procédé peut comprendre : réaliser une plaquette de circuits intégrés comprenant une plaquette de substrat et, sur une face avant de cette dernière et dans différents emplacements, une pluralité des circuits intégrés, cette plaquette de circuits intégrés présentant une face avant du côté de ces circuits intégrés ; réaliser un empilage comprenant une première plaquette au-dessus de la face avant de la plaquette et une seconde plaquette au-dessus de la première plaquette ; réaliser, dans les différents emplacements, des trous au travers de la plaquette de substrat par la face arrière de cette dernière et remplir ces trous d'une matière conductrice de façon à obtenir des vias de connexion électrique reliés sélectivement aux circuits intégrés ; réaliser, dans les différents emplacements, des moyens arrière de connexion électrique extérieure sur la face arrière de la plaquette de substrat, ces moyens arrière de connexion électrique étant sélectivement reliés aux vias de connexion électrique ; enlever ou démonter la seconde plaquette ; singulariser les dispositifs semi-conducteurs obtenus dans les emplacements, chaque dispositif semi-conducteur obtenu comprenant une puce de circuits intégrés incluant une portion de la plaquette de circuits intégrés et une plaque incluant une portion de la première plaquette.

Ce procédé peut comprendre : réaliser une plaquette épaisse de circuits intégrés comprenant une plaquette de substrat épaisse ; réaliser ledit empilage ; amincir, par sa face arrière, la plaquette de substrat épaisse de façon à obtenir une plaquette de circuits intégrés amincie ; et réaliser lesdits trous dans la plaquette de substrat amincie.

La première plaquette peut être fixée sur la face avant de la plaquette de circuits intégrés de façon non démontable par l'intermédiaire d'une couche de colle permanente, chaque dispositif semi-conducteur obtenu pouvant inclure une portion de cette couche de colle.

La seconde plaquette peut être fixée sur la première plaquette de façon démontable par l'intermédiaire d'une couche de colle temporaire ou non-permanente.

Les première et seconde plaquettes peuvent être faites dans le même matériau.

La seconde plaquette peut être plus épaisse que la première plaquette.

Les circuits intégrés peuvent comprendre des éléments optiques pour capter ou émettre un rayonnement lumineux, au moins la première plaquette étant une plaquette optique apte à être traversée par le rayonnement lumineux.

Il est également proposé un dispositif semi-conducteur qui comprend une plaquette de circuits intégrés comprenant des circuits intégrés incluant des éléments optiques et munie, devant ces éléments optiques, d'un empilage d'au moins deux plaquettes, dont une plaquette optique située du côté des éléments optiques.

La plaquette optique peut être moins épaisse que l'autre plaquette.

La plaquette optique peut être fixée sur la plaquette de circuits intégrés par l'intermédiaire d'une couche de colle permanente et l'autre plaquette peut être assemblée à la plaquette optique par l'intermédiaire d'une couche de colle temporaire ou non permanente.

Il est également proposé un dispositif semi-conducteur comprenant une puce de circuits intégrés, d'épaisseur réduite, comprenant des circuits intégrés incluant un élément optique et munie d'une plaque optique, d'épaisseur réduite, placée au-dessus de la puce de circuits intégrés, devant l'élément optique. Un tel dispositif peut être utilisé dans un appareillage d'imagerie.

Un dispositif semi-conducteur et un procédé pour sa fabrication vont maintenant être décrits à titre d'exemples non limitatifs, illustrés par le dessin sur lequel :
- la figure 1 représente une coupe d'un dispositif semi-conducteur optique,
- les figures 2 à 7 représentent en coupe des états du dispositif semi-conducteur optique de la figure 1, à différentes étapes de fabrication.

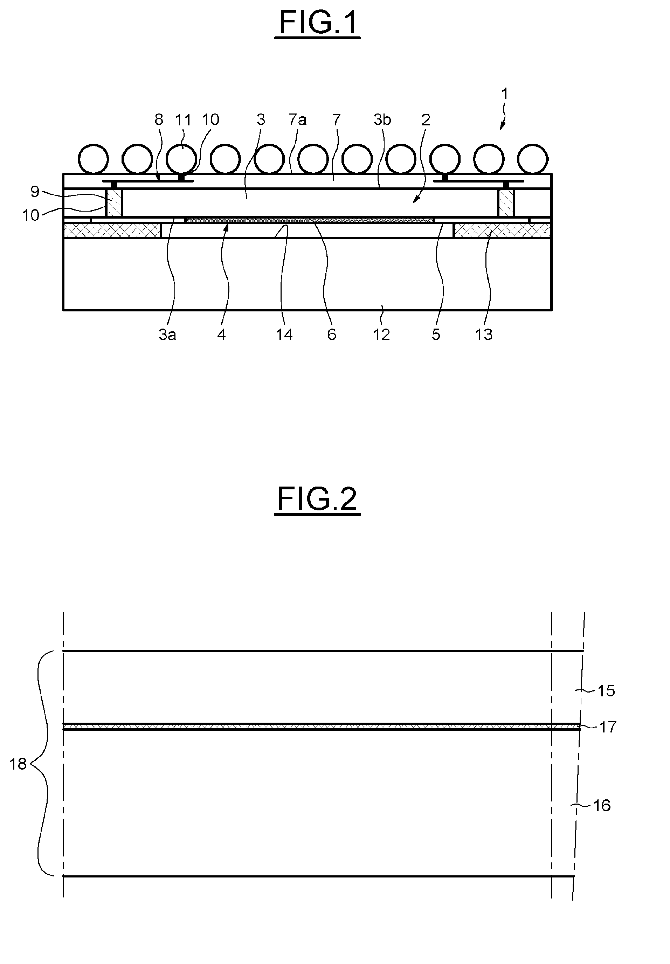

Un dispositif semi-conducteur optique 1, illustré sur la figure 1, comprend une puce de circuits intégrés 2 qui comprend, sur une face avant 3a d'un substrat 3, d'épaisseur réduite, des circuits intégrés 4. Ces circuits intégrés définissent une zone centrale de la face avant 5 de la puce 2, un élément optique intégré 6, par exemple un capteur optique CMOS apte à capter un rayonnement lumineux muni de microlentilles. Dans une variante de réalisation, cet élément optique intégré 5 pourrait être adapté pour émettre un rayonnement lumineux.

Dans une couche arrière 7 formée sur la face arrière 3b du substrat 3 et présentant une face arrière extérieure 7a, la puce 2 comprend un réseau arrière de connexion électrique extérieure 8 qui est sélectivement relié aux circuits intégrés 4 par l'intermédiaire d'une pluralité de vias traversants de connexion électrique 9 aménagés dans des trous 10 traversant le substrat 3. Le réseau arrière de connexion électrique extérieure 8 est muni d'éléments de connexion électrique extérieure 11 tels que des billes métalliques.

Par exemple, la puce 2 peut présenter, entre sa face avant 5 et sa face arrière 7a, une épaisseur comprise entre 50 et 100 microns.

Le dispositif semi-conducteur optique 1 comprend en outre une plaque optique avant 12, d'épaisseur réduite ou mince, qui est placée au-dessus de la puce 2 et qui est fixée sur la face avant 5 de cette dernière par l'intermédiaire d'une couche de colle permanente 13. Cette couche de colle 13 s'étend sur une zone périphérique de la face avant 5 de la puce 2 et sur une zone périphérique de la face arrière 14 de la plaque avant 12, le bord intérieur de la couche de colle 13 étant à distance du bord périphérique du capteur optique 6 de façon à ne pas recouvrir ce dernier.

Par exemple, la plaque optique avant 12 peut présenter une épaisseur comprise entre 50 et 300 microns et la couche de colle 13 peut présenter une épaisseur comprise entre quelques microns et quelques dizaines de microns.

La couche de colle 13 peut être une résine photosensible, par exemple de type benzocyclobutène ou siloxane.

Dans une variante de réalisation, la plaque avant 12 peut être en verre transparent et pourrait être traitée ou recouverte d'une couche adaptée, par exemple de façon à former un filtre optique.

Dans une variante de réalisation, si la colle est transparente, la couche de colle 14 pourrait remplir tout l'espace entre la puce 2 et la plaque avant 12 et recouvrir le capteur optique 5.

En référence aux figures 2 à 6, on va maintenant décrire comment on peut fabriquer, par exemple collectivement, des dispositifs semi-conducteurs optiques 1.

Comme illustré sur la figure 2, on assemble une première plaquette 15 sur une seconde plaquette 16 par l'intermédiaire d'une couche de colle 17, non permanente ou temporaire mais suffisamment résistante, de façon à obtenir un empilage 18. La première plaquette 15 correspond, en épaisseur et en matériau la constituant, à la plaque 12 des dispositifs semi-conducteurs optiques 1 à obtenir.

La seconde plaquette 16 peut être plus épaisse que la première plaquette 15. Par exemple, la seconde plaquette 16 peut présenter une épaisseur comprise entre 400 et 1000 microns.

La seconde plaquette 16 peut être faite dans le même matériau de base que ou dans des matériaux similaires à la première plaquette 15, de façon qu'elles présentent des coefficients de dilatation égaux ou très proches.

Dans une variante de réalisation, on pourrait assembler deux plaques épaisses 15 et 16 et procéder à un amincissement de la plaque 15 pour obtenir l'épaisseur souhaitée de cette dernière.

La couche de colle 17 non permanente ou temporaire peut être en époxyde et acrylate et présenter une épaisseur comprise entre quelques microns et quelques dizaines de microns.

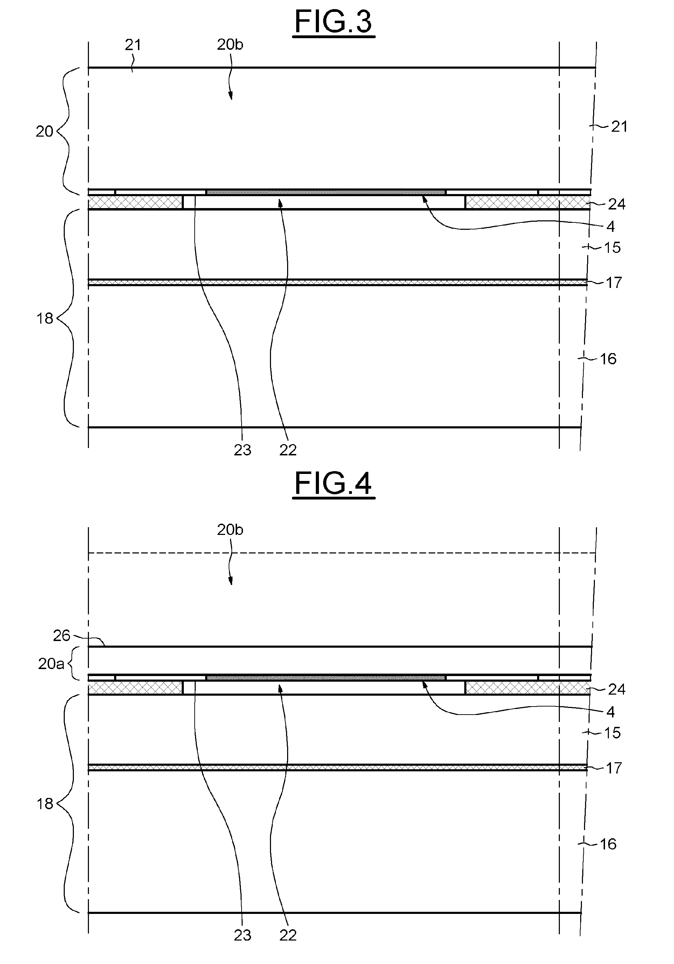

Comme illustré sur la figure 3, on peut avoir préfabriqué une plaquette épaisse de circuits intégrés 20 qui comprend une plaquette de substrat 21 épaisse, sur une face avant de laquelle est formée, en des emplacements 22, une pluralité de circuits intégrés 2, au-dessus desquels la plaquette préfabriquée épaisse de circuits intégrés 20 présente une face avant 23.

On procède alors au montage de l'empilage 18 sur la plaquette épaisse de circuits intégrés 20. Pour cela, on procède au collage de la face arrière 24 de la première plaquette 16, opposée à la seconde plaquette 17, au-dessus de la face avant 23 de la plaquette préfabriquée épaisse de circuits intégrés 20, par l'intermédiaire d'une couche de colle permanente 24 qui correspond, dans chaque emplacement 22, à la couche de colle 13 des dispositifs semi-conducteurs optiques 1 à obtenir. La couche de colle 24 peut être une résine photosensible, par exemple de type benzocyclobutène ou siloxane.

Selon une variante de réalisation, on pourrait tout d'abord fixer la première plaquette 15 au-dessus de la face avant 23 de la plaquette préfabriquée épaisse de circuits intégrés 20, par l'intermédiaire de la couche de colle permanente 24, puis assembler la seconde plaquette 16 au-dessus de la plaquette 15 par l'intermédiaire de la couche de colle non permanente ou temporaire 17. On obtiendrait de la même manière l'empilage 18 au-dessus de la face avant 23 de la plaquette préfabriquée épaisse 20.

Ensuite, comme illustré sur la figure 4, on procède à un amincissement de la plaquette de substrat 21 en enlevant sa partie arrière de façon à obtenir une plaquette de substrat 25 d'épaisseur réduite, dont l'épaisseur correspond à l'épaisseur du substrat 3 des dispositifs semi-conducteurs optiques 1 à obtenir. Cette opération peut être réalisée par un procédé mécano-chimique ou mécanique, par exemple par polissage. On obtient alors une plaquette de circuits intégrés amincie 20a.

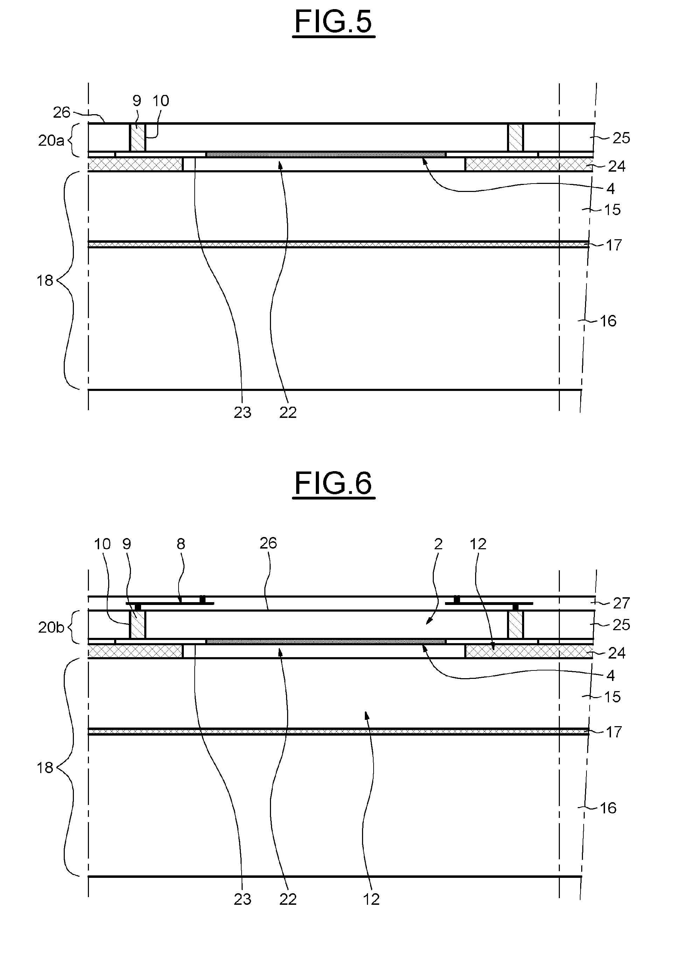

Puis, comme illustré sur la figure 5, on procède, en chaque emplacement 22, par la face arrière 26 de la plaquette de substrat d'épaisseur réduite 25, à la réalisation de trous 9 dans cette plaquette de substrat 25 et au remplissage de ces trous 9 de façon à former les vias 8 des dispositifs semi-conducteurs optiques 1 à obtenir.

Puis, comme illustré sur la figure 6, on procède à la réalisation, sur la face arrière 26 de la plaquette de substrat d'épaisseur réduite 25, d'une couche 27, qui, dans chaque emplacement 22, correspond à la couche 6 et intègre un réseau arrière de connexion électrique 8. On obtient alors une plaquette de circuits intégrés complète 20b.

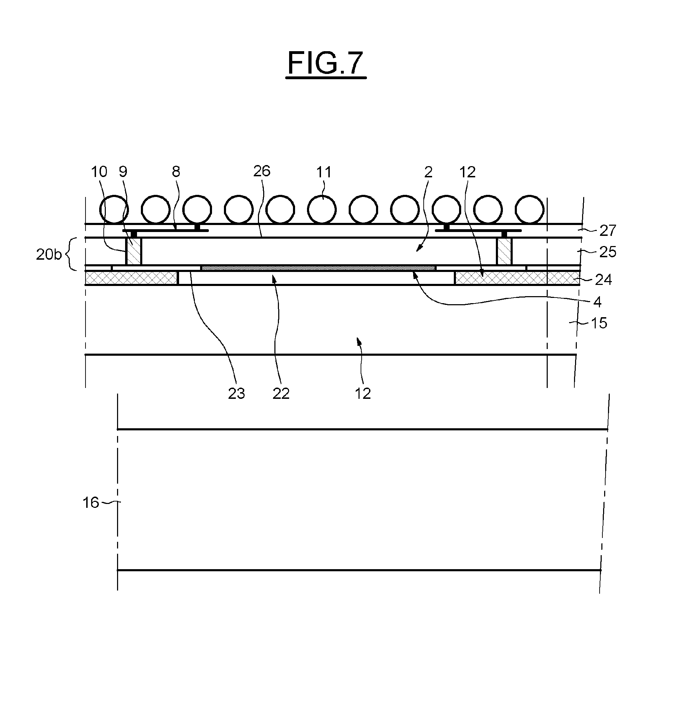

Après quoi, comme illustré sur la figure 7, on procède à l'enlèvement ou au démontage de la seconde plaquette 16 en détruisant la couche de colle temporaire ou non-permanente 17, par exemple en appliquant une température élevée, de l'ordre de 175°C et en faisant glisser la plaquette 16 par rapport à la plaquette 15.

Ensuite, on peut procéder à un nettoyage de la face découverte de la première plaquette 15 de façon à enlever les résidus de la couche de colle 17.

Ensuite, on procède, dans chaque emplacement 22, à la mise en place des éléments arrière de connexion électrique extérieure 11, tels que des billes de connexion électrique.

Enfin, on procède à une singularisation des différents dispositifs semi-conducteurs optiques 1 obtenus dans les différents emplacements 22, par exemple par sciage entre ces emplacements 22, dans chacun lesquels la puce de circuits intégrés 2 inclut une portion de la plaquette de circuits intégrés complète 20b, munie des trous 10, des moyens de connexion électrique 8 et des éléments de connexion électrique 11, la plaque optique 12 inclut une portion de la plaquette optique 15 et la couche de colle 13 inclut une portion de la couche de colle 24.

On obtient alors le dispositif semi-conducteur 1 de la figure 1.

Il résulte de ce qui précède que, lors de la réduction de l'épaisseur de la plaquette de substrat 25 et lors de la fabrication des vias de connexion électrique 9 et des moyens arrière de connexion électrique 8 et 11, l'existence de l'empilage 18 des plaquettes 15 et 16 assure la résistance mécanique souhaitée et que les dispositifs semi-conducteurs 1 obtenus, ne comprennent que la plaque optique 12 issue de la plaquette 15, dont l'épaisseur peut être faible, de telle sorte que les effets de cette plaque optique 12 sur le rayonnement lumineux la traversant peuvent être réduits, par exemple lorsque la distance focale des moyens optiques placés en avant de l'élément optique intégré 6 et de la plaque 12 est très courte.

La présente invention ne se limite pas aux exemples ci-dessus décrits. Bien d'autres variantes de réalisation sont possibles, sans sortir du cadre défini par les revendications annexées.

## Revendications

1. Procédé de fabrication de dispositifs semi-conducteurs, comprenant :
réaliser une plaquette de circuits intégrés (20a) comprenant une plaquette de substrat (25) et, sur une face avant de cette dernière et dans différents emplacement (22), une pluralité des circuits intégrés (4), cette plaquette de circuits intégrés présentant une face avant (23) du côté de ces circuits intégrés ;
réaliser un empilage (18) comprenant une première plaquette (15) au-dessus de la face avant (23) de la plaquette et une seconde plaquette (16) au-dessus de la première plaquette ;
réaliser, dans les différents emplacements (22), des trous (10) au travers de la plaquette de substrat (25) par la face arrière de cette dernière et remplir ces trous d'une matière conductrice de façon à obtenir des vias de connexion électrique (9) reliés sélectivement aux circuits intégrés ;
réaliser, dans les différents emplacements (22), des moyens arrière de connexion électrique extérieure (8, 11) sur la face arrière (26) de la plaquette de substrat (25), ces moyens arrière de connexion électrique étant sélectivement reliés aux vias de connexion électrique (9) ;
enlever ou démonter la seconde plaquette (16) ;
singulariser les dispositifs semi-conducteurs obtenus dans les emplacements, chaque dispositif semi-conducteur obtenu (1) comprenant une puce de circuits intégrés (2) incluant une portion de la plaquette de circuits intégrés (20a) et une plaque (12) incluant une portion de la première plaquette (15).

2. Procédé selon la revendication 1, comprenant :
réaliser une plaquette épaisse de circuits intégrés (20) comprenant une plaquette de substrat épaisse (21) ;
réaliser ledit empilage (18) ;
amincir, par sa face arrière, la plaquette de substrat épaisse de façon à obtenir une plaquette de circuits intégrés amincie (20a) ;
et réaliser lesdits trous (10) dans la plaquette de substrat amincie (25).

3. Procédé selon l'une des revendications 1 et 2, dans lequel la première plaquette (15) est fixée sur la face avant (22) de la plaquette de circuits intégrés (20a) de façon non démontable par l'intermédiaire d'une couche de colle permanente (24), chaque dispositif semi-conducteur obtenu incluant une portion (13) de cette couche de colle.

4. Procédé selon l'une quelconque des revendications précédentes, dans lequel la seconde plaquette est fixée sur la première plaquette de façon démontable par l'intermédiaire d'une couche de colle temporaire ou non-permanente (17).

5. Procédé selon l'une quelconque des revendications précédentes, dans lequel les première et seconde plaquettes (15, 16) sont faites dans le même matériau.

6. Procédé selon l'une quelconque des revendications précédentes, dans lequel la seconde plaquette (16) est plus épaisse que la première plaquette (15).

7. Procédé selon l'une quelconque des revendications précédentes, dans lequel les circuits intégrés comprennent des éléments optiques (6) pour capter ou émettre un rayonnement lumineux, au moins la première plaquette (15) étant une plaquette optique apte à être traversée par le rayonnement lumineux.

8. Dispositif semi-conducteur comprenant une plaquette de circuits intégrés (20a) comprenant des circuits intégrés (4) incluant des éléments optiques (6) et munie, devant ces éléments optiques, d'un empilage d'au moins deux plaquettes (15, 16), dont une plaquette optique (15) située du côté des éléments optiques.

9. Dispositif selon la revendication 8, dans lequel la plaquette optique (15) est moins épaisse que l'autre plaquette (16).

10. Dispositif selon l'une des revendications 8 et 9, dans lequel la plaquette optique (15) est fixée sur la plaquette de circuits intégrés (20a) par l'intermédiaire d'une couche de colle permanente (24) et l'autre plaquette (16) est assemblée à la plaquette optique (15) par l'intermédiaire d'une couche de colle temporaire ou non permanente (17).

11. Dispositif semi-conducteur comprenant une puce de circuits intégrés (2), d'épaisseur réduite, comprenant des circuits intégrés (4) incluant un élément optique (6) et munie d'une plaque optique (12), d'épaisseur réduite, placée au-dessus de la puce de circuits intégrés (2), devant l'élément optique (6).

12. Appareillage d'imagerie comprenant au moins un dispositif selon la revendication 11.
